# EUROPEAN PATENT APPLICATION

(11) **EP 1 086 814 A2**
(43) Date of publication of application: **28.03.2001**
(21) Application number: 00120236.5
(22) Date of filing: 26.09.2000
(51) Int. Cl.: B41J 2/14, B41J 2/16

(54) **Inkjet recording head and method for manufacturing same**

(30) Priority: 27.09.1999 JP 27172199
(71) Applicant: NEC CORPORATION, Tokyo (JP)
(72) Inventor: Sato, Junya, Minato-ku, Tokyo (JP)
(74) Representative: VOSSIUS & PARTNER

(57) **Abstract**

An ink jet recording head including: a chamber housing (17) which defines a plurality of pressure chambers (172); a plurality of piezoelectric elements (11) on the chamber housing (17) corresponding to one of said pressure chambers (172), each of said piezoelectric elements (11) having thereon first and second electrode (13, 14), each of the electrodes (13, 14) having an electrode terminal; and a circuit board (21) having side surfaces mounting thereon a drive terminal (22) disposed for each of said electrode terminals, and wherein the electrode terminal and a corresponding one of said drive terminals (22) are connected together. Since the piezoelectric elements (11) and the circuit board (21) are connected with each other by a solidified solder fillet (23), an excellent long-term reliability of the recording head and a reduction of a defection rate thereof can be secured.

## Description

The present invention relates to an inkjet recording head and a method for manufacturing the same, more in particular to a piezoelectric element corresponding a pressure chamber and a connection structure with a driving circuit for providing a driving signal to the piezoelectric element and a method for connecting the same.

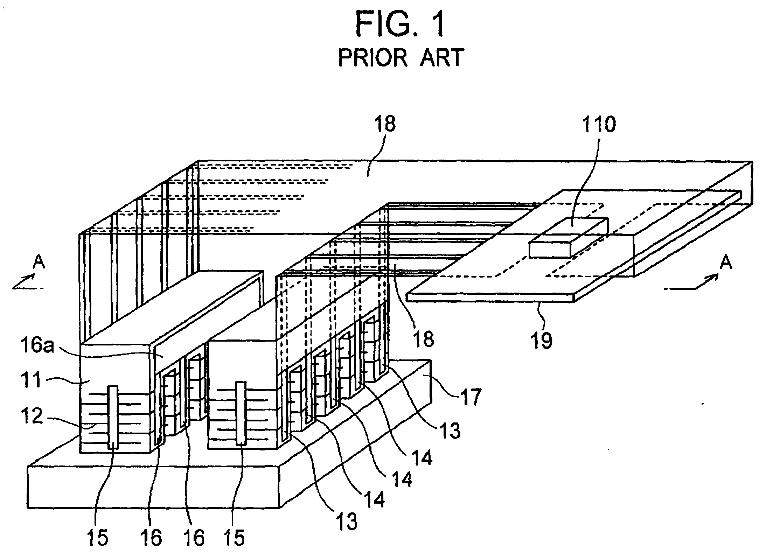

A conventional inkjet recording head shown in Fig.1 includes a stacked chamber 17 which has thereon a pair of stacked piezoelectric elements 11 opposing to each other.

The stacked piezoelectric elements 11 formed to be comb-like include a plurality of internal electrodes 12 at the comb-like portion. At the comb-like portion, internal electrodes 12 having one end exposed to the outside of the opposing piezoelectric elements 11, and internal electrodes 12' having one end exposed between the opposing piezoelectric elements 11 are alternately stacked.

On both the ends (front surface of bottom surface in direction perpendicular to the surface of the drawing) of the comb-like portions of the respective piezoelectric elements 11, the three internal electrodes 12 exposing the respective one ends to the outside of the piezoelectric elements 11 are connected to one other by a longitudinal external electrode 13 for common signals, and the three internal electrodes 12' having one end exposed between the opposing piezoelectric elements 11 are connected to one other by a longitudinal external electrode for connecting common electrodes 16. On both the ends of the comb-like portion, the six internal electrodes 12 exposing to the front surface of the piezoelectric element 11 are connected to one other by a longitudinal external electrode 13 for connecting the internal electrodes 15.

On three comb-like portions in the middle of the piezoelectric element 11, the three internal electrodes 12 exposing the respective one ends to the outside of the piezoelectric elements 11 are connected to one other by a longitudinal external electrode 14 for individual signals, and the three internal electrodes 12' having one end internally exposed are connected to one other by an external electrode 16 for connecting common electrodes The plurality of the external electrode 16 for connecting common electrodes in each of the piezoelectric elements 11 are connected to one other by a connecting plate 16a.

A printing circuit board 19 mounting an IC chip 110 for switching is connected to the longitudinal external electrode 13 for the common signals and the longitudinal external electrode 14 for the individual signals through intermediary of an FPC (flexible printing circuit board) 18. The IC chip 110 is connected to a controlling circuit (not shown) through the intermediary of the printing circuit board 19.

The stacked chamber 17 includes a vibration plate 171 and a nozzle plate 173 opposing to each other, and a plurality of pressure chambers 172 divided by partition plates 175 between the vibration plate 171 and the nozzle plate 173. Ink-ejecting nozzles 174 are formed in the nozzle plate 173 corresponding to each of the pressure chambers 172, and the pair of the piezoelectric elements 11 are fixed on the vibration plate 171 through the intermediary of an electric connection element 111. The FPC 18 is connected to the stacked piezoelectric elements 11 through the intermediary of the electric connection element 111.

In the inkjet recording head having the above configuration, each of the comb-like portions of the stacked piezoelectric elements 11 vibrates by selectively applying a driving voltage from the IC chip 110 for switching through the intermediary of the printing circuit board 19 and the FPC to the piezoelectric elements 11, and the vibration is transmitted from the vibration plate 171 to the pressure chamber 172. Thereby, ink selectively ejects from the ink-ejecting nozzles 174, and the printing is conducted on a recording medium such as recording paper.

In the recording apparatus mounting the above conventional inkjet recording head, a signal input terminal of an interconnect is also a target of miniaturization because the ink-ejecting nozzle 174 is required to be miniaturized. Accordingly, the connection between the external electrodes 13, 14 acting as the signal input terminal of a piezoelectric signal and the FPC acting as the signal output terminal of the driving circuit are collectively conducted in view of cost and productivity. For example, the plurality of the FPCs 18 are collectively connected to the external electrodes 13, 14 and the printing circuit board 19 by forming a solder plating film on the connection terminal of the FPC 18 and applying direct heating and pressure to the plating film.

However, in the conventional connecting method, a large difference between the coefficients of thermal expansion of the piezoelectric elements 11 and the FPC 18 makes a difference in an amount of expansion and/or contraction after at the time of the cooling after the application of the heat and the pressure and after the connection. The difference is likely to generate problems of short-circuit between terminals and irregularity of a connection resistance at each of the terminal connecting parts after the connection, thereby possibly deteriorating an excellent long-term reliability of the recording head. If a plurality of the stacked piezoelectric elements 11 are mounted at a higher density, the number of the terminals and the FCTs 18 exponentially increases a defection rate of the ink ejecting characteristics.

The control of the temperature at the time of the heat and pressure application and of the value and the distribution of the pressure is difficult, and problems such as the irregularity of the connection resistance similar to those already described are likely to occur. Accordingly, an applied voltage as designed or excellent ink ejecting characteristics may not obtained.

In view of the foregoing, an object of the present invention is to provide an inkjet recording head which secures an excellent long-term reliability and an excellent applied voltage by averting a short-circuit between terminals and irregularity of connection resistances, and realizes a higher printing quality by suppressing the increase of a defection rate of ink ejecting characteristics even if a plenty of stacked piezoelectric elements are mounted at a higher density.

The present invention provides, in a first aspect thereof, an ink jet recording head including: a chamber housing which defines a plurality of pressure chambers; a plurality of piezoelectric elements each mounted by said chamber housing corresponding to one of said pressure chambers, each of said piezoelectric elements having thereon first and second electrodes for driving a corresponding one of said pressure chambers, each of said first and second electrodes having an electrode terminal disposed on one of end surfaces of each of said piezoelectric elements; and a circuit board having a bottom surface mounted by top surfaces of said plurality of said piezoelectric elements, a top surface mounting thereon a drive circuit and side surfaces mounting thereon a drive terminal disposed for each of said electrode terminals and connected to said drive circuit; said electrode terminal and a corresponding one of said drive terminals being connected together.

The present invention provides, in a second aspect thereof, a method for manufacturing an inkjet recording head including the steps of: placing a solder fillet on a top end of each of a plurality of electrode terminals of a piezoelectric element; placing, on the piezoelectric element, a circuit board mounting a drive circuit thereon and a plurality of drive terminals on end surfaces thereof such that each of the top ends of the electrode terminals is in contact with the corresponding drive terminal; and heating and melting the solder fillet for connecting the drive terminal and the electrode terminal with each other.

In accordance with the first and the second aspects of the present invention, an inkjet recording head which secures an excellent long-term reliability and an excellent applied voltage by averting a short-circuit between terminals and irregularity of connection resistances, and realizes a higher printing quality by suppressing the increase of a defection rate of ink ejecting characteristics even if a plenty of stacked piezoelectric elements are mounted at a higher density.

The above and other objects, features and advantages of the present invention will be more apparent from the following description.

### BRIEF DESCRIPTION OF DRAWINGS

Fig.1 is a perspective view showing a bonding state between stacked piezoelectric elements and a substrate.

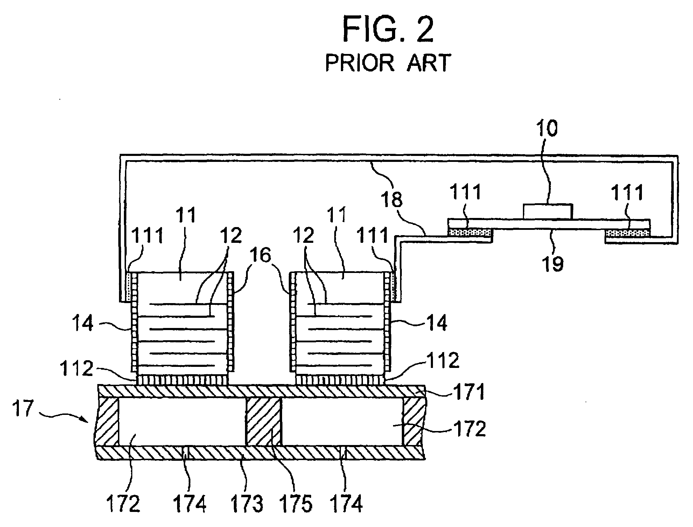

Fig 2 is a longitudinal sectional view taken along a line A-A in Fig.1.
Fig.3 is a perspective view showing a main configuration of an inkjet recording head in accordance with an embodiment of the present invention.
Fig.4 is a longitudinal sectional view taken along a line B-B in Fig.3.
Fig.5 is a perspective view showing the substrate of the embodiment of the present invention.
Fig.6 is an enlarged perspective view showing the portion of Fig.5 designated by an arrow C.
Fig.7 is a perspective view showing a step of preparing a solder fillet in Example 1.
Fig.8 is a perspective view showing a step of melting the solder fillet in Example 1.
Fig.9 is a perspective view showing a bonding state between stacked piezoelectric elements and a substrate in Example 1.
Fig.10 is a perspective view showing a step of melting the solder fillet in Example 2.
Fig 11 is a perspective view showing a bonding state between stacked piezoelectric elements and a substrate in Example 2.

### PREFERRED EMBODIMENTS OF THE INVENTION

Now, the present invention is more specifically described with reference to accompanying drawings.

### Embodiment

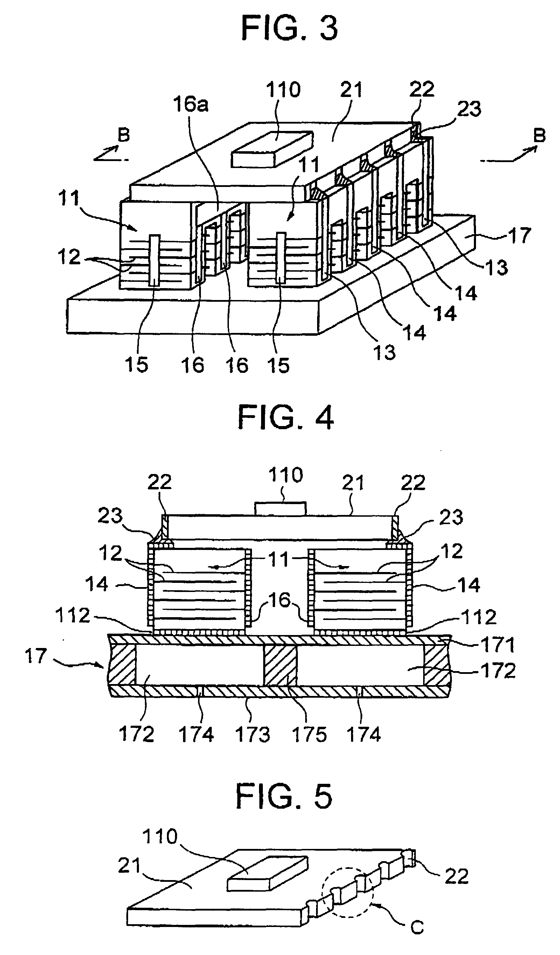

An inkjet recording head in accordance with an embodiment of the present invention shown in Fig.3 includes a stacked chamber (chamber housing) 17 and a pair of stacked piezoelectric elements 11 opposing to each other formed on the stacked chamber 17. The stacked piezoelectric elements 11 which provides vibration are formed to be comb-like.

Each of the comb-like portions of both the piezoelectric elements 11 includes a plurality of internal electrodes 12. At the comb-like portion, the internal electrodes 12 having one end exposed to the outside of the opposing piezoelectric elements 11, and the internal electrodes 12 having one end exposed between the opposing piezoelectric elements 11 are alternately stacked.

On the both ends of the comb-like portions of the respective piezoelectric elements 11, the three internal electrodes 12 exposing the respective one ends to the outside of the piezoelectric elements 11 are connected to one other by a longitudinal external electrode 13 for common signals, and the three internal electrodes 12' having one end exposed between the opposing piezoelectric elements 11 are connected to one other by a longitudinal external electrode 13 for connecting common electrodes 16. On the both ends of the comb-like portion, the six internal electrodes 12 exposing to the front surface of the piezoelectric element 11 are connected to one other by a longitudinal external electrode 13 for connecting the internal electrodes 15.

A ceramic substrate (circuit board) 21 is disposed bridging both the stacked piezoelectric elements 11. The ceramic substrate 21 includes a plurality of end electrodes (drive terminals) 22 on its both side surfaces as shown in Fig.4, and each of the end electrodes 22 is connected to the corresponding external electrodes 13, 14. An IC chip 110 is mounted on the top central portion of the ceramic substrate 21. The IC chip 110 for switching includes a driving circuit selectively applying a driving voltage to the piezoelectric elements 11 through the intermediary of the respective end electrodes 22, and is connected to a controlling circuit (not shown) controlling the driving circuit through the intermediary of interconnect (not shown) connected to the ceramic substrate 21.

The stacked chamber 17 includes a vibration plate 171 forming an ink flowing path and a nozzle plate 173 opposing to each other, and a plurality of pressure chambers 172 divided by partition plates 175 between the vibration plate 171 and the nozzle plate 173. Ink-ejecting nozzles 174 are formed in the nozzle plate 173 corresponding to each of the pressure chambers 172, and the pair of the piezoelectric elements 11 opposing to each other are fixed on the vibration plate 171. The piezoelectric elements 11 generate pressure change in the pressure chambers 172 by the vibration in the longitudinal direction in Fig.4 by an electric signal from the ceramic substrate 21, and eject ink droplets through the ink-ejecting nozzles 174 of the nozzle plate 173.

The width of the ceramic substrate 21 is formed narrower than the distance between the outward-facing end surfaces of the piezoelectric elements 11. Each of the top portions of the external electrodes 13, 14 is inwardly bent and inserted between the bottom portion of the end electrode 22 and the top surface of the piezoelectric element 11. A solder fillet is formed on the inwardly bent portion of the external electrodes 13, 14 and connects the external electrodes 13, 14 and the end electrode 22 to each other. The "solder fillet" in the present invention used herein is a fillet material made of solder for connecting two members crossing substantially perpendicularly with each other for attaining similar objects and effects to those of the well-known fillet material. The solder fillet is preferably formed in a shape of a triangle having, as its two sides, the end electrode and the external electrode or the electrode terminal.

Examples of fixing the ceramic substrate 21 on the piezoelectric elements 11 will be described referring Figs.5 to 9.

### Example 1

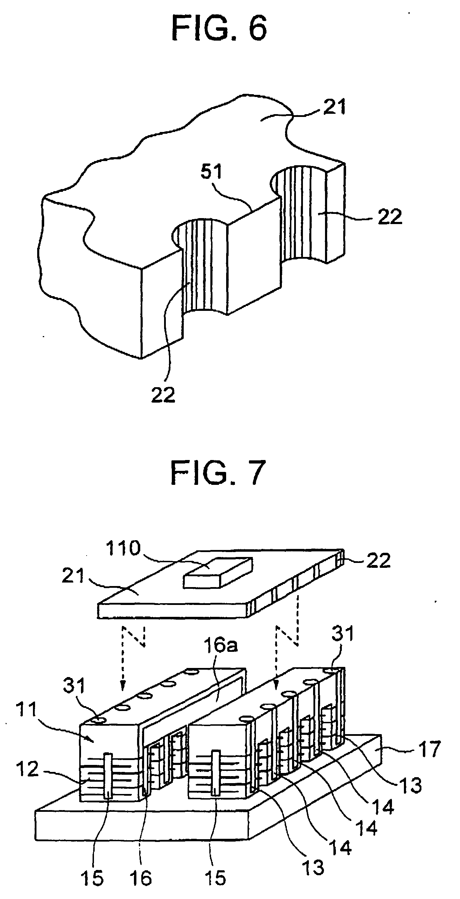

As shown in Fig.7, Ag/Pd (silver-palladium alloy) was printed and stoved on each of the comb-like portions of the piezoelectric elements 11, and sputtered using a mask or etched after the sputtering on the entire surface, thereby forming external electrodes 13 to 16.

Then, concaves for end electrodes 22 were formed on both end surfaces of a ceramic substrate 21 in a pitch corresponding to a distance between a longitudinal external electrode 13 for common signals and a longitudinal external electrode 14 for individual signals as shown in Fig.5.

The end electrode 22 may be fabricated by stacking a plurality of soft sheets each having an interconnect pattern, forming via-holes penetrating the plurality of the sheets, thermally treating the stacked sheets for curing and diving the stacked sheets along a contour line 51 passing the centers of the via holes. Although the formation of electrodes on the side surface of a circuit board ordinarily requires a plenty of steps and a high cost, the semicircular end electrodes 22 as shown in Fig.6 can be obtained by the above simplified procedures in accordance with present Example. Since, further, the melted solder smoothly moves along the inner semicircular surface to be adhered on substantially the entire surface of the end electrodes 22, the connection between the external electrodes 13, 14 and the end electrodes 22 is secured and the procedures for the connection is simplified.

Then, the IC chip 110 for switching was mounted on the ceramic substrate 21, and the IC chip 110 and a controlling circuit (not shown) are connected to each other through the intermediary of the ceramic substrate 21.

Then, as shown in Fig.7, solder paste 31 was applied on the external electrode 13 for common signals and the external electrode 14 for individual signals by printing using a metal mask located on the piezoelectric elements 11. The ceramic substrate 21 was precisely positioned on the solder paste-applied surface of the piezoelectric elements 11.

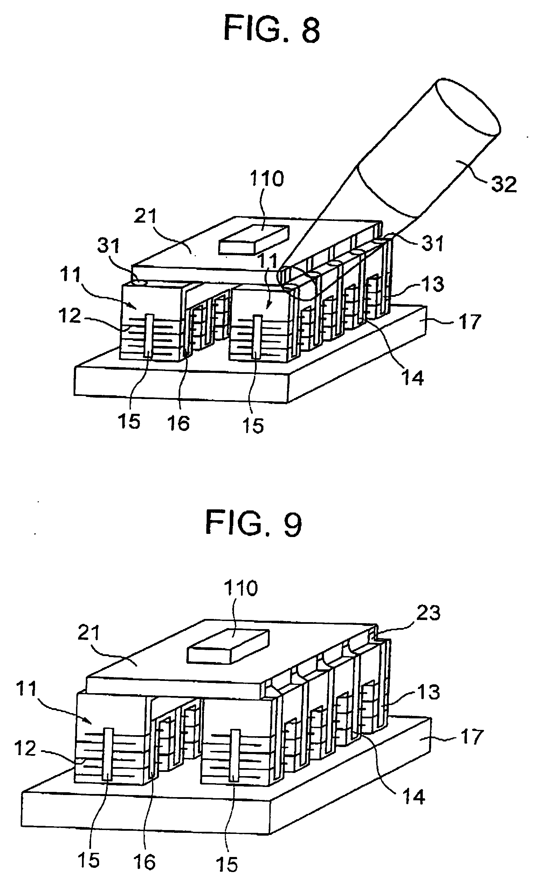

Then, as shown in Fig.8, a beam from a halogen lamp 32 was concentrated on and locally irradiated to the solder paste 31 between the piezoelectric elements 11 and the ceramic substrate 21. All the solder paste 31 was sequentially heated and melted by moving the local irradiation in a two-dimensional manner.

As shown in Fig.9, the piezoelectric elements 11 and the ceramic substrate 21 were connected with each other by a solder fillet 23 formed by the melting and the curing of the solder paste 31 in the above procedure.

The heating device for melting the solder paste 31 includes a xenon lamp, a laser beam irradiator and a reflow furnace which entirely heats the piezoelectric elements 11 and the ceramic substrate 21 accommodated therein.

### Example 2

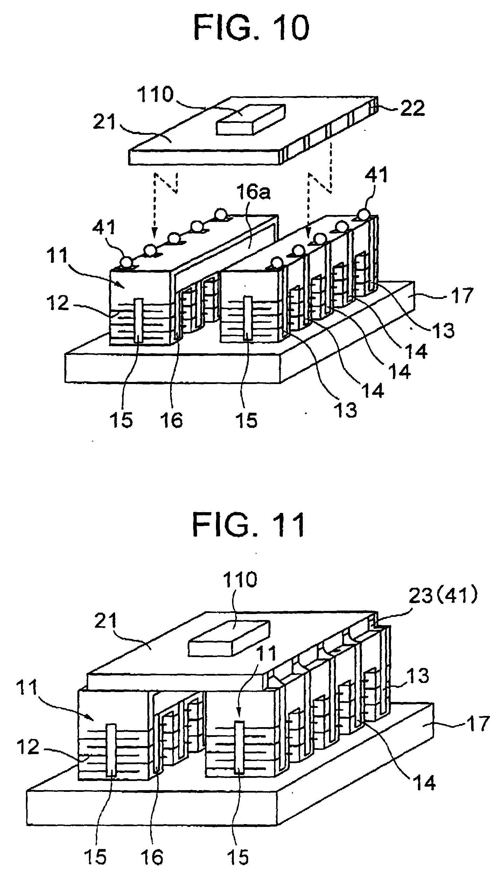

As shown in Fig.10, after external electrodes 13 for common signals and external electrodes 14 for individual signals were formed on piezoelectric elements 11, molded solders (solid solder) 41 formed in a shape of a ball in advance were placed on the external electrodes 13, 14 corresponding to the top surface of the piezoelectric elements 11 by using a molded solder mounting apparatus (not shown), thereby retaining the molded solders on the external electrodes 13, 14 by the viscosity of the applied flux. The ceramic substrate 21 was precisely positioned on the piezoelectric elements 11 such that the end electrodes 22 were in contact with the row of the molded solders 41.

Then, as shown in Fig.11, the piezoelectric elements 11 and the ceramic substrate 21 were electrically and mechanically connected with each other by a solidified solder fillet 23 formed by the melting and the curing of the solder paste 31 between the piezoelectric elements 11 and the ceramic substrate 21 by using a heating device similar to that of Example 1.

Since the ceramic substrate 21 was directly connected to and fixed to the piezoelectric elements 11 by using the solder fillet 23 in accordance with the embodiment and Examples 1 and 2 of the present invention, the pressurization is unnecessary and the temperature control at the time of the heating can be easily conducted. Accordingly, inconveniences such as a short-circuit conventionally occurring between the piezoelectric element 11 acting as a signal input terminal at the interconnect end and the FPC 18 acting a signal output terminal of the IC chip 110 of the external driving side, and irregularity of a connection resistance at each of the terminal connecting parts can be prevented.

The ordinary coefficients of linear thermal expansion of the piezoelectric element 11, the conventional FPC and the ceramic substrate 21 are 1.4e⁻⁶/°C, 18e⁻⁶/°C and 5 to 7 e⁻⁶/°C, respectively. The use of the ceramic substrate 21 enables to prevent the reduction of a dimensional accuracy due to a difference of thermal expansions between heating and cooling, and the reduction of a positional precision. Since, further, occurrence of an internal distortion at the connected portion due to the difference of the thermal expansions between the heating and the cooling can be suppressed minimum, a long-term reliability of the recording head can be secured.

Since the above embodiments are described only for examples, the present invention is not limited to the above embodiments and various modifications or alternations can be easily made therefrom by those skilled in the art without departing from the scope of the present invention.

## Claims

1. An ink jet recording head characterized by comprising:
a chamber housing (17) which defines a plurality of pressure chambers (172);
a plurality of piezoelectric elements (11) each mounted by said chamber housing (17) corresponding to one of said pressure chambers (172), each of said piezoelectric elements (11) having thereon first and second electrodes (13, 14) for driving a corresponding one of said pressure chambers (172), each of said first and second electrodes (13, 14) having an electrode terminal disposed on one of end surfaces of each of said piezoelectric elements (11); and
a circuit board (21) having a bottom surface mounted by top surfaces of said plurality of said piezoelectric elements (11), a top surface mounting thereon a drive circuit (110) and side surfaces mounting thereon a drive terminal (22) disposed for each of said electrode terminals and connected to said drive circuit (110);
said electrode terminal and a corresponding one of said drive terminals (22) being connected together.

2. The ink jet recording head as defined in claim 1, wherein said side surface is inwardly offset from said end surface of said piezoelectric elements (11), and said electrode terminal and the corresponding one of said drive terminals are connected through a solder fillet (23) disposed at a corner region defined by one of said side surfaces of said circuit board (21) and said top surface of each of said piezoelectric elements (11).

3. The inkjet recording head as defined in claim 1 or 2, wherein said drive terminal (22) includes a semicircular concave shape formed on said side surface of said circuit board (21), and the first and the second electrode (13, 14) is located perpendicular to the horizontal direction of the drive terminal (22).

4. The inkjet recording head as defined in claim 2, wherein a top end of said electrode terminal is in contact with said top surface of said piezoelectric element (11), and the solder fillet (23) is in contact with a longitudinal surface of the drive terminal (22) and a horizontal surface of the top end of the electrode terminal.

5. The inkjet recording head as defined in any of claims 1 to 4, wherein the circuit board (21) is made of ceramics.

6. A method for manufacturing an inkjet recording head characterized by comprising the steps of:
placing a solder fillet (23) on a top end of each of a plurality of electrode terminals of a piezoelectric element (11);
placing, on the piezoelectric element (11), a circuit board (21) mounting a drive circuit (110) thereon and a plurality of drive terminals (22) on end surfaces thereof such that each of the top ends of the electrode terminals is in contact with the corresponding drive terminal (22); and
heating and melting the solder fillet (23) for connecting the drive terminal (22) and the electrode terminal with each other.

7. The method as defined in claim 6, wherein the heating of the solder fillet (23) is conducted by a device including a halogen lamp, a xenon lamp, a laser beam irradiator and a re-flow furnace.
